Europäisches Patentamt

**European Patent Office**

**Office européen des brevets**

(19)

(11) **EP 1 111 770 B1**

(12) **FASCICULE DE BREVET EUROPEEN**

(45) Date de publication et mention
de la délivrance du brevet:
**19.03.2003 Bulletin 2003/12**

(51) Int Cl.⁷: **H03B 5/36**, H03H 9/215,
H03B 5/04

(21) Numéro de dépôt: **99125480.6**

(22) Date de dépôt: **21.12.1999**

(54) **Dispositif oscillateur à quartz basse fréquence ayant un comportement thermique amélioré**

Oszillatoranordnung für einen Niederfrequenz-Quarz und mit verbessertem Temperatur-Verhalten

Oscillator arrangement for low-frequency quartz and having an improved temperature dependency

(84) Etats contractants désignés:
**AT BE CH CY DE DK ES FI FR GB GR IE IT LI LU
MC NL PT SE**

(43) Date de publication de la demande:
**27.06.2001 Bulletin 2001/26**

(73) Titulaires:
- **Eta SA Fabriques d'Ebauches
2540 Grenchen (CH)**
- **EM Microelectronic-Marin SA
2074 Marin (CH)**

(72) Inventeurs:
- **Dalla Piazza, Silvio
2610 Saint-Imier (CH)**

- **Novac, Pinchas
2000 Neuchâtel (CH)**

(74) Mandataire: **Ravenel, Thierry Gérard Louis et al
I C B,
Ingénieurs Conseils en Brevets SA,
7, rue des Sors
2074 Marin (CH)**

(56) Documents cités:
**EP-A- 0 657 994          GB-A- 2 042 796
US-A- 4 320 320          US-A- 4 498 025**

**Description**

La présente invention concerne généralement un dispositif oscillateur à quartz basse fréquence.

Dans la suite de la présente description, on entendra par "dispositif oscillateur à quartz" un dispositif oscillateur comprenant un résonateur à quartz associé à des moyens oscillateurs ou circuit électronique d'entretien des oscillations du résonateur.

L'homme du métier connaît divers types de dispositifs oscillateurs à quartz. L'homme du métier connaît en particulier des dispositifs oscillateurs employant un résonateur à quartz agencé pour vibrer selon un mode de vibration en flexion. De tels résonateurs présentent typiquement un comportement thermique de type parabolique et sont relativement sensibles aux variations de température.

Afin de pallier à cet inconvénient, l'homme du métier sait que la sensibilité de tels oscillateurs à des changements de température peut être compensée ou tout du moins réduite par des moyens additionnels, ou circuit de compensation thermique. Outre le fait que ces moyens additionnels augmentent les coûts de tels oscillateurs, on constate que la consommation de ces dispositifs croît également sensiblement. Par ailleurs, ces moyens additionnels de compensation thermique fonctionnent typiquement par l'ajustement de ou des capacités de charge du résonateur ou par l'adjonction ou la suppression d'impulsions d'oscillation. Ceci a pour effet de dégrader fortement la pureté du spectre de fréquence du signal d'oscillation. On constate en effet l'apparition d'un grand nombre de raies spectrales de largeur assez importantes, la position de ces raies variant en outre avec la température.

Ces dispositifs oscillateurs ne peuvent être utilisés dans les cas où il est nécessaire de disposer d'un signal d'oscillation ayant non seulement une fréquence stable en température mais également un spectre de fréquence ne comportant qu'un nombre réduit de raies spectrales. Un signal présentant ces propriétés est par exemple nécessaire en télécommunication pour permettre une opération de synchronisation.

L'homme du métier connaît également des oscillateurs comportant un résonateur à quartz de coupe dite AT présentant un comportement thermique de type cubique et dont la fréquence est très stable en fonction de la température. Toutefois, par nature, cette fréquence est assez élevée, de l'ordre de quelques MHz. En conséquence, pour utiliser un tel dispositif oscillateur pour délivrer un signal d'oscillation basse fréquence, il convient de pourvoir cet oscillateur d'un circuit diviseur de fréquence, ce qui complique et renchérit ce dispositif. En outre, l'énergie électrique consommée par ce circuit diviseur de fréquence est relativement importante du fait de la fréquence élevée du signal qu'il reçoit à son entrée, ce qui s'avère être un grave inconvénient lorsque cette énergie doit être fournie par une source d'alimentation autonome de faibles dimensions telles qu'une pile d'une montre-bracelet.

Un but général de la présente invention est donc de proposer un dispositif oscillateur à quartz qui pallie aux inconvénients susmentionnés, c'est-à-dire un dispositif oscillateur qui produit un signal d'oscillation ayant un bon comportement thermique et une bonne pureté spectrale et qui consomme préférablement peu.

A cet effet, la présente invention a pour objet un dispositif oscillateur à quartz dont les caractéristiques sont énoncées à la revendication 1.

La présente invention se propose ainsi, en premier lieu, d'utiliser un résonateur à quartz de type torsion, c'est-à-dire un résonateur agencé pour vibrer selon un mode de vibration en torsion. Selon la présente Invention, ce résonateur est en particulier un résonateur du type décrit dans l'article de MM. Roger Bourquin et Philippe Truchot intitulé "Barreaux de quartz vibrant en mode de torsion, Application aux capteurs", 6ème Congrès Européen de Chronométrie (CEC), Bienne, 17-18 octobre 1996, qui est incorporé ici par référence.

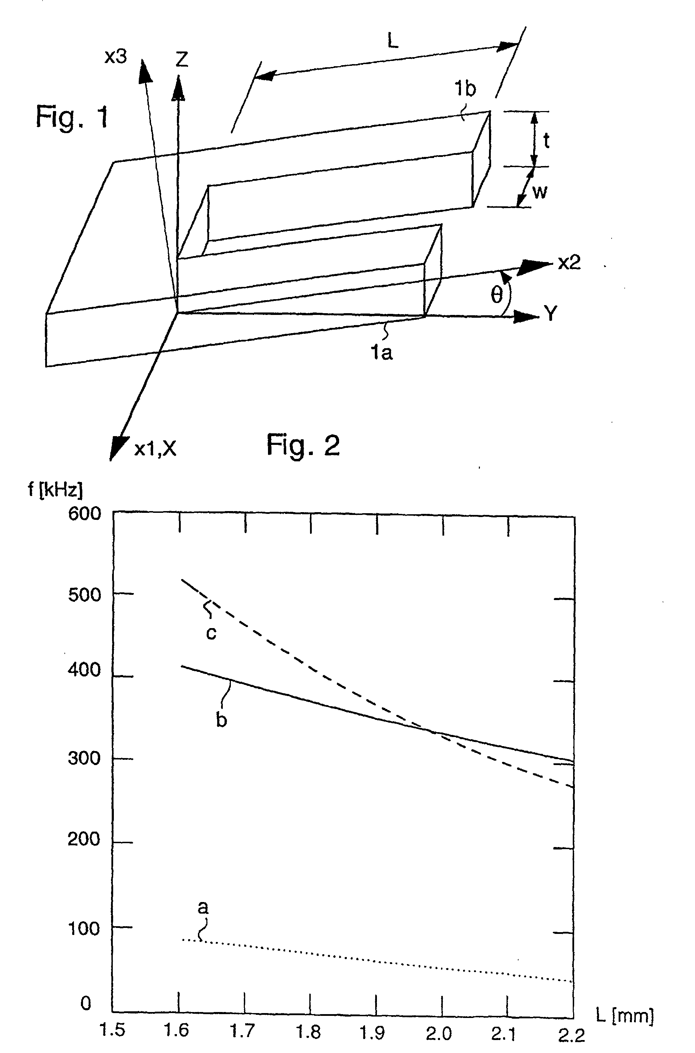

La figure 1 annexée montre un exemple non limitatif d'un tel résonateur de type torsion, indiqué globalement par la référence' numérique 1. Ce résonateur 1 se présente sous la forme d'un diapason obtenu par découpage chimique ou mécanique dans une plaque de quartz selon un angle de coupe déterminé de sorte que les branches du résonateur sont orientées dans le plan cristallographique YZ du cristal de quartz selon un angle déterminé θ comme cela ressort clairement de la figure 1.

Ce type de résonateur présente l'avantage d'un meilleur comportement thermique par rapport aux résonateurs conventionnels vibrant en flexion. En particulier, le comportement thermique de ce résonateur vibrant en torsion est déterminé par l'angle de coupe θ et par le rapport épaisseur sur largeur (t/w) de la branche. A titre d'exemple, un résonateur diapason vibrant en torsion réalisé selon l'enseignement de l'article susmentionné permet d'obtenir une meilleure stabilité thermique, de l'ordre d'un facteur 3, par rapport à un résonateur diapason conventionnel vibrant en flexion.

On notera que l'on connaît également un autre type de résonateur agencé pour vibrer selon un mode de torsion. Cet autre résonateur vibrant en torsion est connu sous la dénomination résonateur à quartz de coupe TT. Un tel résonateur est par exemple décrit dans l'article de MM. Hirofumi Kawashima et Mitsuhiro Nakazato intitulé "TT-Cut Torsional Quartz Crystal Resonator", 45th Annual Symposium on Frequency Control (ASFC), IEEE, 1991.

A la différence du résonateur vibrant en torsion du précédent article, qui est utilisé dans le cadre de la présente invention, ce résonateur est caractérisé par deux angles de coupe et nécessite une structure d'électrode plus complexe. En termes de facilité de fabrication et de coûts, le résonateur vibrant en torsion décrit dans l'article de MM. Bourquin et Truchot susmentionné constitue donc une solution plus avantageuse.

On constatera néanmoins qu'un inconvénient du résonateur vibrant en torsion décrit dans le premier article susmentionné réside dans le fait qu'il présente, outre le mode fondamental de vibration en torsion désiré, des modes de vibration en flexion non désirés. Comme on le verra ultérieurement en détail, ce type de résonateur présente notamment un mode fondamental de vibration en flexion à une fréquence sensiblement plus basse que la fréquence du mode fondamental de torsion désiré. De ce fait, si un tel résonateur est associé à un circuit électronique d'entretien conventionnel, l'ensemble oscillera en pratique selon ce mode fondamental de flexion et non selon le mode fondamental de torsion désiré.

La présente invention se propose ainsi de répondre également à cet inconvénient propre au résonateur vibrant en torsion susmentionné, à savoir fournir un circuit électronique d'entretien des oscillations du résonateur assurant que le résonateur vibre effectivement selon le mode fondamental de vibration en torsion désiré.

Selon une résolution particulièrement avantageuse du résonateur, la géométrie du résonateur est choisie de sorte que le mode fondamental de vibration en torsion désiré se situe sensiblement au voisinage de 393,216 kHz, soit 12 fois la fréquence de 32,768 kHz qui est la fréquence typique d'un résonateur à quartz destiné aux applications horlogères.

Ces objets, caractéristiques et avantages, ainsi que d'autres, de la présente invention apparaîtront plus clairement à la lecture de la description détaillée qui suit, faite en référence aux dessins annexés donnés à titre d'exemples non limitatifs et dans lesquels :

- la figure 1 déjà présentée, montre un exemple d'un résonateur à quartz vibrant en torsion utilisé dans le cadre de la présente invention et se présentant sous la forme d'un diapason dont les branches sont orientées dans le plan cristallographique YZ;
- la figure 2 montre, dans le cas d'une réalisation spécifique du résonateur de la figure 1, l'évolution de la fréquence de trois de ses principaux modes de vibration en fonction de la longueur de branche du résonateur, ces trois modes de vibration étant le mode fondamental de vibration en torsion, le mode fondamental de vibration en flexion et le premier overtone de flexion;
- la figure 3a montre schématiquement un dispositif oscillateur à inverseur utilisé dans le cadre de la présente invention;
- la figure 3b montre un exemple de réalisation du dispositif oscillateur de la figure 3a comportant un Inverseur CMOS;
- la figure 4 montre un schéma électrique équivalent d'un résonateur à quartz; et
- la figure 5 est un diagramme illustrant les conditions limites d'oscillation $g_{m,min}$ et $g_{m,max}$ pour chacun des trois principaux modes de vibration considérés du résonateur utilisé dans le cadre de la présente en fonction de la valeur de la résistance de contre-réaction $R_F$ du circuit électronique d'entretien.

On s'attardera tout d'abord brièvement sur le résonateur à quartz vibrant en torsion utilisé comme résonateur dans le dispositif oscillateur selon la présente invention. De plus amples informations peuvent être trouvées dans l'article de MM. Roger Bourquin et Philippe Truchot déjà mentionné plus haut.

En se référant à nouveau à la figure 1, le résonateur à quartz vibrant en torsion est avantageusement réalisé sous la forme d'un diapason obtenu par découpage mécanique ou chimique dans une plaque de quartz selon un angle de coupe déterminé. On notera que cette réalisation particulière n'est nullement limitative et que d'autres géométries de résonateur peuvent être envisagées. Ce résonateur peut ainsi alternativement être réalisé sous la forme d'un unique barreau ou sous la forme de deux barreaux montés de manière symétrique et opposée autour d'un encastrement central.

Le résonateur diapason de la figure 1, repéré globalement par la référence numérique 1, comporte deux branches 1a et 1b de section rectangulaire (épaisseur t, largeur w) et de longueur (L) orientées dans le plan cristallographique YZ. Sur la figure 1, on a également illustré un référentiel (x1; x2; x3) associé au résonateur 1 tel que la longueur L est définie selon l'axe x2 et l'épaisseur t est définie selon l'axe x3. En particulier, ce référentiel (x1; x2; x3) associé au résonateur 1 est orienté par rapport aux axes cristallographiques X, Y et Z de sorte que l'axe x1 est confondu avec l'axe cristallographique X, et les axes x2 et x3 forment chacun un angle déterminé e par rapport aux axes cristallographiques Y et Z respectivement.

Le résonateur 1 utilisé dans le cadre de la présente invention présente ainsi un unique angle de coupe défini par une rotation d'un angle déterminé θ autour de l'axe cristallographique X du cristal de quartz.

On comprendra de l'article de MM. Bourquin et Truchot que le comportement thermique du résonateur est déterminé par l'angle d'orientation du résonateur (angle θ) et par le rapport épaisseur (t) sur largeur (w), ou rapport de section, de la branche du résonateur. En particulier, l'angle d'orientation θ ainsi que le rapport de section sont choisis de sorte que le coefficient thermique de premier ordre ou coefficient linéaire est sensiblement nul. En pratique, ce résultat peut par exemple être obtenu, avec un angle d'orientation θ de +32° et un rapport de section de l'ordre de 0.6.

La Demanderesse a ainsi pu constater qu'en réalisant un résonateur diapason selon l'enseignement de MM. Bourquin et Truchot, on améliore le comportement thermique de ce résonateur de l'ordre d'un facteur 3 par rapport à un résonateur diapason vibrant en flexion.

Il est important de noter que ce résonateur comporte, outre le mode fondamental de vibration en torsion désiré, également désigné ci-après par les termes "mode de torsion fondamental", des modes de vibration en flexion non désirés. En particulier, ce résonateur comporte un premier mode non désiré, à savoir un mode fondamental de vibration en flexion, également désigné ci-après par les termes "mode de flexion fondamental", se situant à une fréquence sensiblement plus basse que la fréquence du mode de torsion fondamental désiré. Ce résonateur comporte par ailleurs un autre mode de vibration non désiré qu'il convient également de considérer, à savoir un autre mode de vibration en flexion, désigné ci-après par les termes "premier overtone de flexion", se situant à une fréquence relativement proche de la fréquence du mode de torsion fondamental désiré.

Préférablement, les dimensions du résonateur, à savoir les dimensions t, w et L de la branche du résonateur, sont choisie de sorte que le mode de torsion fondamental désiré se trouve entre le mode de flexion fondamental et le premier overtone de flexion susmentionnés. Comme on le verra plus en détail ultérieurement ceci est préférable pour assurer un fonctionnement adéquat du dispositif oscillateur selon la présente invention.

A titre d'illustration, la figure 2 montre l'évolution de la fréquence de chacun des modes de vibration susmentionnés en fonction de la longueur L de la branche pour une réalisation spécifique du résonateur diapason dont les dimensions des branches sont en particulier $w = 220\ \mu m$ et $t = 136\ \mu m$. Dans cette figure, la courbe repérée "a" illustre l'évolution de la fréquence du mode de flexion fondamental, la courbe repérée "b" illustre l'évolution de la fréquence du mode de torsion fondamental et la courbe repérée "c" illustre l'évolution de la fréquence du premier overtone de flexion.

A titre d'exemple non limitatif mais particulièrement avantageux, la géométrie du résonateur diapason de la figure 1 est en outre choisie de sorte que le mode de torsion fondamental désiré se situe sensiblement au voisinage de 393,216 kHz, soit 12 fois la fréquence de 32,768 kHz qui est la fréquence typique d'un résonateur à quartz destiné aux applications horlogères. Dans l'illustration de la figure 2, ce résultat est par exemple obtenu pour une longueur de branche L d'environ 1,68 mm.

On notera bien évidemment que les dimensions indiquées ci-dessus ne le sont qu'à titre purement illustratif et non limitatif. D'autres dimensions peuvent être choisies pour remplir les conditions dictées par l'application désirée.

Selon la réalisation spécifique utilisée ici à titre d'exemple, le résonateur diapason comporte ainsi un mode de torsion fondamental désiré se situant sensiblement à 393,216 kHz. Conformément à l'illustration de la figure 2, ce résonateur comporte par ailleurs un mode de flexion fondamental, non désiré, dont la fréquence se situe sensiblement au voisinage de 74 kHz, et un premier overtone de flexion, également non désiré, dont la fréquence se situe sensiblement au voisinage de 435 kHz.

Selon la pratique courante, les circuits d'entretien des oscillations du résonateur sont typiquement conçus pour que le dispositif oscillateur oscille selon le premier mode de vibration du résonateur, à savoir communément le mode de vibration ayant la fréquence la plus basse. Ceci est typiquement le cas des dispositifs oscillateurs employant des résonateurs vibrant en flexion. Dans le cas particulier qui nous concerne ici, le résonateur présente un premier mode de vibration, à savoir un mode fondamental de vibration en flexion, qui est un mode non désiré. L'association d'un circuit d'entretien conventionnel et du résonateur vibrant en torsion utilisé dans le cadre de la présente invention conduira typiquement à ce que le dispositif oscillateur n'oscille pas selon le mode désiré, à savoir le mode de torsion fondamental dont la fréquence se situe sensiblement à 393,216 kHz, mais sur le premier mode de vibration du résonateur, à savoir le mode de flexion fondamental non désiré dont la fréquence se situe au voisinage de 74 kHz. L'explication de ce problème est présentée dans la suite de la présente description.

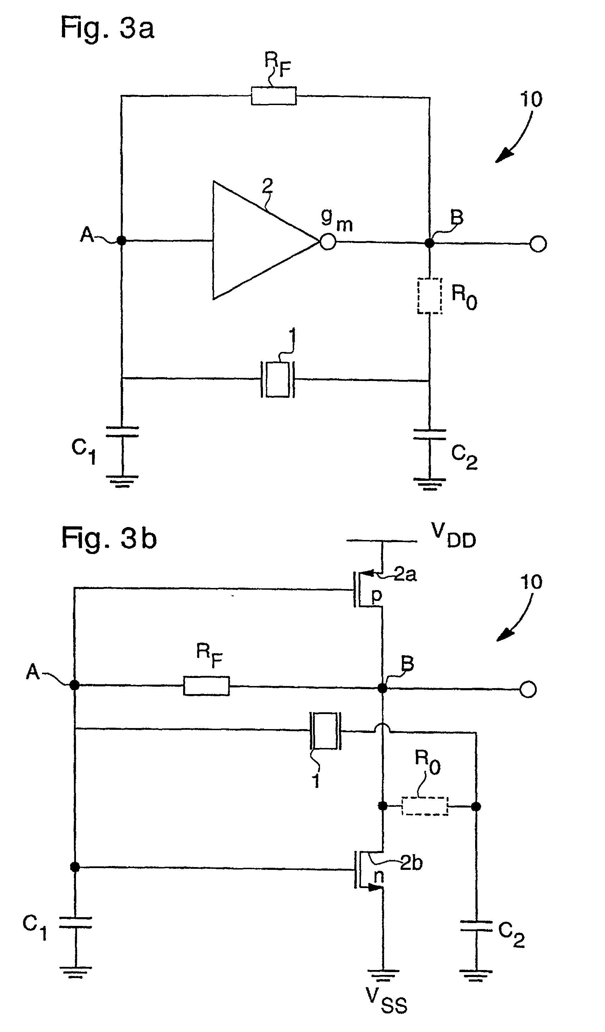

En référence à la figure 3a, il est représenté de manière schématique un dispositif oscillateur 10 comprenant un amplificateur inverseur 2 ayant une valeur de transconductance $g_m$, un résonateur 1 connecté dans le chemin de contre-réaction de l'inverseur 2, une première capacité de charge $C_1$ connectée sur l'entrée A de l'inverseur 2, et une seconde capacité de charge $C_2$ connectée sur la sortie B de l'inverseur 2. Le dispositif oscillateur 10 comporte en outre une résistance de contre-réaction ou résistance de feedback $R_F$ connectée entre l'entrée A et la sortie B. Typiquement la valeur de cette résistance de contre-réaction $R_F$ est choisie très élevée et son influence sur le fonctionnement du dispositif oscillateur est généralement négligée.

Au titre de perfectionnement, le dispositif oscillateur de la figure 3a peut en outre comprendre une résistance additionnelle $R_0$ disposée entre la sortie B de l'inverseur 2 et la capacité de charge $C_2$. Cette résistance est destinée à assurer une amélioration de la stabilité du dispositif oscillateur.

Une réalisation envisageable du dispositif oscillateur de la figure 3a est présentée à la figure 3b. Selon cette réalisation, l'amplificateur inverseur 2 est par exemple un inverseur CMOS comportant un premier transistor 2a de type p et un second transistor 2b de type n connectés drain à drain entre un potentiel de masse $V_{SS}$ et un potentiel d'alimentation $V_{DD}$ et dont les terminaux de grille sont connectés en commun. Dans un tel cas, la transconductance $g_m$ de l'amplificateur inverseur 2 est égale à la somme des transconductances des transistors de type p et n 2a et 2b.

Une explication détaillée du fonctionnement d'un dispositif conforme au dispositif oscillateur de la figure 3b peut par exemple être trouvée dans l'article de M. Andreas Rusznyak, "Start-Up Time of CMOS Oscillators", IEEE Transactions on Circuits and Systems, vol. cas-34, no.3, mars 1987.

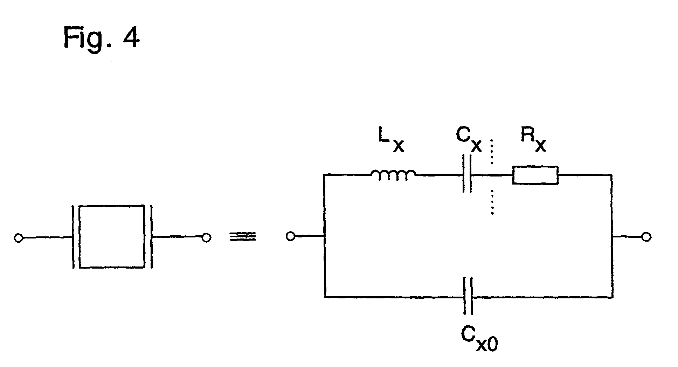

Il est bien connu de la littérature que le résonateur 1 peut être représenté par son circuit électrique équivalent tel qu'illustré à la figure 4. Selon cette représentation, le résonateur 1 comporte une branche série comprenant une grande inductance $L_x$, une faible capacité $C_x$ et une résistance série $R_x$, et, connectée en parallèle avec la branche série, une capacité dite statique $C_{x0}$. Il est à noter que le circuit équivalent de la figure 4 est valable au voisinage d'un mode de vibration donné du résonateur et qu'à chaque mode de vibration donné du résonateur correspond une branche série $L_x$, $C_x$, $R_x$ spécifique.

On notera que l'inductance $L_x$ et la capacité $C_x$ sont représentatives du comportement dynamique du mode de vibration considéré du résonateur et que la résistance série $R_x$ représente les pertes de ce résonateur. On notera en outre que la valeur de la capacité statique $C_{x0}$ est typiquement très supérieure à la valeur de la capacité $C_x$ de la branche série. On peut ainsi définir que la fréquence (angulaire) des oscillations du dispositif est sensiblement égale à :

$$\omega \cong \frac{1}{\sqrt{L_x C_x}} \tag{1}$$

Les conditions nécessaires pour que l'oscillation du dispositif oscillateur ait effectivement lieu selon un mode de vibration donné peuvent être définies comme suit.

Selon une première de ces conditions, la transconductance $g_m$ du dispositif oscillateur doit être supérieure à la transconductance critique ou transconductance minimale $g_{m,min}$ définie dans l'expression (2) ci-dessous :

$$g_{m,min} = (2 + \frac{C_1}{C_2} + \frac{C_2}{C_1}) \left[ \omega^2 R_x (C_0 + \frac{C_1 C_2}{C_1 + C_2})^2 + \frac{1}{R_F} \right] \tag{2}$$

où $\omega$ est la fréquence (angulaire) de résonance pour le mode de vibration considéré et $C_0$ est la capacité présente en parallèle avec le résonateur 1 et comprend notamment la capacité statique $C_{x0}$ de ce résonateur. Pour le dimensionnement des capacités de charges $C_1$ et $C_2$, il conviendra, le cas échéant, de tenir compte également de l'influence des capacités parasites présentes en parallèle avec ces capacités de charge sur l'entrée et la sortie de l'amplificateur inverseur. A titre d'exemple, la valeur de la capacité $C_0$ est estimée dans le cas particulier à 1 pF et les valeurs des capacités $C_1$ et $C_2$ sont dimensionnées à 12 pF et 28 pF respectivement.

En complément de la condition (2) exprimée ci-dessus, une deuxième condition doit être remplie par la transconductance $g_m$ pour que l'oscillation du dispositif oscillateur ait lieu. L'oscillation du dispositif n'est en effet par ailleurs possible que si la transconductance $g_m$ de l'amplificateur inverseur est inférieure à la transconductance maximale $g_{m,max}$ définie selon l'expression (3) suivante :

$$g_{m,max} = \frac{C_1 C_2}{R_x C_0^2 + 1/(\omega^2 R_F)} \tag{3}$$

On notera, en règle générale, que la valeur de transconductance maximale $g_{m,max}$ est typiquement sensiblement supérieure à la transconductance critique $g_{m,min}$.

Les conditions d'oscillation du dispositif peuvent être résumée comme suit :

$$g_{m,min} < g_m < g_{m,max} \tag{4}$$

Si la condition (4) exprimée ci-dessus est remplie simultanément pour plusieurs modes de vibration, on sait que l'oscillation du dispositif ne se fera en pratique qu'au mode de vibration présentant la transconductance critique $g_{m,min}$ la plus faible. Dans le cas qui nous concerne, le mode de vibration désiré du résonateur, à savoir le mode fondamental de vibration en torsion, se situe à une fréquence (393,216 kHz) sensiblement plus élevée que le mode fondamental de vibration en flexion non désiré (à 74 kHz). La transconductance critique $g_{m,min}$ du mode de flexion fondamental non désiré est ainsi typiquement inférieure à la transconductance critique $g_{m,min}$ du mode de torsion fondamental désiré. En conséquence, l'oscillation du dispositif ne se fera typiquement que selon le mode de flexion fondamental non désiré.

Pour répondre à ce problème, et contrairement à la pratique courante, on exploite la dépendance de la transconductance critique $g_{m,min}$ et de la transconductance maximale $g_{m,max}$ vis-à-vis de la résistance de contre-réaction $R_F$ dans les expressions (2) et (3) ci-dessus afin d'éviter que le dispositif n'oscille selon le mode fondamental de vibration en flexion non désiré.

On peut constater que la transconductance critique $g_{m,min}$ décroît très sensiblement lorsque la valeur de résistance de contre-réaction $R_F$ augmente pour atteindre rapidement une valeur sensiblement constante déterminée par les caractéristiques du résonateur et les capacités de charge $C_1$ et $C_2$. En particulier, pour des valeurs de résistance de contre-réaction $R_F$ telles que :

$$R_F >> \frac{1}{\omega^2 R_x (C_0 + \frac{C_1 C_2}{C_1 + C_2})^2} \tag{5}$$

l'expression (2) de la transconductance critique $g_{m,min}$ peut se réduire sensiblement à l'expression simplifiée (6) suivante :

$$g_{m,min} \cong \omega^2 R_x \frac{[C_1 C_2 + C_0(C_1 + C_2)]^2}{C_1 C_2} \tag{6}$$

On peut ainsi constater que la valeur de transconductance critique $g_{m,min}$ dépend essentiellement, pour chaque mode de vibration considéré, du facteur $\omega^2 R_x$. Ce sont donc essentiellement les caractéristiques du résonateur, à savoir la fréquence du mode considéré ainsi que sa valeur de résistance série qui déterminent la valeur de la transconductance critique $g_{m,min}$.

De même, on peut constater que la transconductance maximale $g_{m,max}$ décroît sensiblement lorsque la valeur de résistance de contre-réaction $R_F$ diminue pour atteindre une valeur sensiblement proportionnelle à cette résistance de contre-réaction $R_F$. En particulier, pour des valeurs de résistance de contre-réaction $R_F$ telles que :

$$R_F << \frac{1}{\omega^2 R_x C_0^2} \tag{7}$$

l'expression (3) de la transconductance maximale $g_{m,max}$ peut se réduire sensiblement à l'expression simplifiée (8) suivante :

$$g_{m,max} \cong C_1 C_2 \omega^2 R_F \tag{8}$$

On peut constater, dans ce cas, que la valeur de transconductance maximale $g_{m,max}$ dépend essentiellement, pour chaque mode de vibration considéré, du facteur $\omega^2 R_F$. C'est donc essentiellement la fréquence du mode considéré et la résistance de contre-réaction $R_F$ qui déterminent la valeur de la transconductance maximale $g_{m,max}$. On constate ainsi que la transconductance maximale $g_{m,max}$ est d'autant plus faible que la fréquence du mode de vibration considéré est faible.

Reprenons, à titre d'illustration, la réalisation particulière du résonateur, mentionnée ci-dessus, utilisée dans le cadre de la présente invention, à savoir le résonateur possédant un mode de flexion fondamental se situant au voisinage de 74 kHz, un mode de torsion fondamental se situant sensiblement à 393,216 kHz et un premier overtone de flexion se situant au voisinage de 435 kHz. Selon cette réalisation spécifique du résonateur, les résistances série $R_x$ sont estimées en moyenne pour chacun de ces modes à environ 56 kΩ, 8 kΩ et 23 kΩ respectivement.

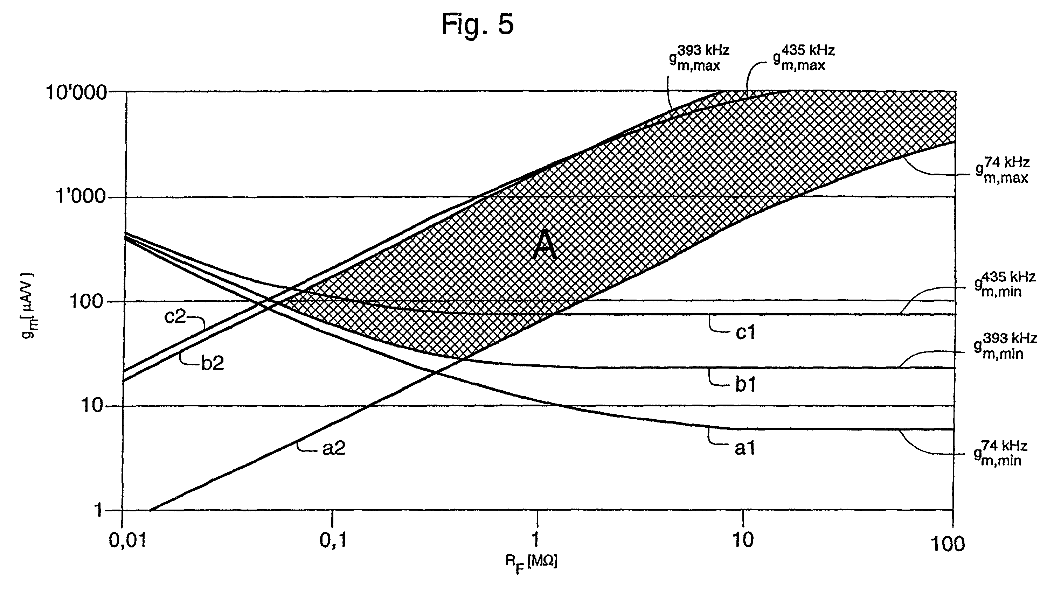

La figure 5 présente un diagramme de l'évolution de la transconductance critique $g_{m,min}$ et de la transconductance maximale $g_{m,max}$ en fonction de la valeur de la résistance de contre-réaction $R_F$. Les courbes $a_1$, $b_1$ et $c_1$ représentent ainsi l'évolution de la transconductance critique $g_{m,min}$ pour chacun des modes de vibration susmentionnés, à savoir respectivement le mode de flexion fondamental, le mode de torsion fondamental et le premier overtone de flexion. De même, les courbes $a_2$, $b_2$ et $c_2$ représentent l'évolution de la transconductance maximale $g_{m,max}$ pour chacun des trois modes de vibration considérés.

Selon la présente Invention, afin d'assurer l'oscillation du dispositif selon le mode de torsion fondamental désiré, on doit satisfaire aux conditions qui suivent.

Pour assurer l'oscillation du dispositif selon le mode désiré, à savoir le mode de torsion fondamental, la transconductance $g_m$ du dispositif doit en premier lieu satisfaire à la condition générale (4) énoncée ci-dessus, c'est-à-dire, dans le cas particulier pris à titre d'exemple :

$$g_{m,min}^{393kHz} < g_m < g_{m,max}^{393kHz} \tag{9}$$

De plus, afin d'éviter que le dispositif n'oscille selon le mode de flexion fondamental non désiré, la transconductance $g_m$ du dispositif doit par ailleurs être supérieure à la transconductance maximale $g_{m,max}$ du mode de flexion fondamental non désiré, c'est-à-dire, dans le cas particulier pris à titre d'exemple :

$$g_{m,max}^{74kHz} < g_m \tag{10}$$

Dans le cas présent, il convient également de s'assurer que la transconductance critique $g_{m,min}$ du mode de torsion fondamental désiré soit inférieure à la transconductance critique $g_{m,min}$ du premier overtone de flexion. Dans le cas contraire, le dispositif oscillerait selon le premier overtone de flexion. Dans le cas particulier pris à titre d'exemple, cette condition peut être énoncée comme suit :

$$g_{m,min}^{393kHz} < g_{m,min}^{435kHz} \tag{11}$$

Dans la figure 5, on a schématisé par la zone grisée A, l'ensemble de valeurs de transconductance $g_m$ satisfaisant aux conditions (9) et (10) ci-dessus. La condition (11) est quant à elle satisfaite par un choix adéquat des caractéristiques du résonateur. En particulier, comme cela a déjà été mentionné, le résonateur est préférablement conçu de sorte que la fréquence du mode de torsion fondamental désiré se trouve en dessous de la fréquence du premier overtone de flexion non désiré. Il convient ainsi d'attacher une attention tout particulière à la réalisation du résonateur et de s'assurer que les valeurs de résistance série $R_x$ de ces modes de vibration sont telles que la relation (11) ci-dessus reste satisfaite.

On aura compris de ce qui précède qu'un choix judicieux de la valeur de résistance de contre-réaction $R_F$ permet de remplir les conditions (9) et (10) tout en assurant une valeur de transconductance $g_m$ relativement faible, ce qui est préférable du point de vue de la consommation. Dans le cas présent, illustré à la figure 5, on choisit par exemple une valeur de résistance de contre-réaction $R_F$ de l'ordre de 700 à 800 kΩ permettant de réduire la transconductance maximale relative au mode de flexion fondamental non désiré à quelques dizaines de μA/V. Pour cette même valeur de résistance de contre-réaction $R_F$, la transconductance maximale relative au mode de torsion fondamental désiré est quant elle de l'ordre de quelques mA/V et assure ainsi une tolérance suffisante sur la transconductance $g_m$ du dispositif.

Selon la présente invention, on réalise ainsi un dispositif oscillateur agencé pour osciller selon le mode fondamental de vibration en torsion du résonateur à quartz. De ce fait, le comportement thermique du dispositif oscillateur selon la présente invention est sensiblement amélioré par rapport à un dispositif oscillateur conventionnel employant un résonateur à quartz vibrant en flexion.

Au titre de variante avantageuse, le dispositif oscillateur peut être équipé d'un circuit diviseur connecté sur la sortie B du circuit d'entretien. En particulier, dans le cas spécifique du dispositif oscillateur pris ici à titre d'exemple, à savoir un dispositif oscillateur agencé pour délivrer un signal d'oscillation à 393,216 kHz, ce signal peut avantageusement être appliqué sur l'entrée d'un circuit diviseur par douze de manière à dériver un signal d'oscillation ayant une fréquence sensiblement égale à 32,768 kHz, ce signal étant particulièrement utile pour des applications horlogères.

D'une manière générale, le résonateur sera réalisé de telle sorte que le mode fondamental de vibration en torsion désiré se situe à une fréquence égale à un mutliple de 32,768 kHz.

En pratique, on réalisera par ailleurs avantageusement le dispositif oscillateur selon la présente invention sous la forme d'un unique composant compact comportant par exemple un boîtier céramique, métallique ou plastique dans lequel sont disposés le résonateur à quartz ainsi que le circuit électronique d'entretien des oscillations.

On comprendra que différentes modifications et/ou adaptations peuvent être apportées au dispositif oscillateur décrit dans la présente description sans toutefois sortir du cadre de l'invention définie par les revendications annexées.

**Revendications**

1. Dispositif oscillateur basse fréquence comportant un résonateur à quartz et un circuit électronique d'entretien des oscillations dudit résonateur à quartz, **caractérisé en ce que** :

   - ledit résonateur à quartz présente un unique angle de coupe défini par une rotation d'un angle déterminé ($\theta$) autour de l'axe cristallographique X dudit quartz, de sorte que ledit résonateur comporte au moins un mode fondamental de vibration en flexion à une première fréquence et un mode fondamental de vibration en torsion à une deuxième fréquence supérieure à ladite première fréquence; et
   - ledit circuit électronique d'entretien des oscillations du résonateur est un circuit à amplificateur inverseur (2) dont la valeur de transconductance ($g_m$) est déterminée de sorte que ledit dispositif ne peut pas osciller selon ledit mode fondamental de vibration en flexion mais selon ledit mode fondamental de vibration en torsion dudit résonateur.

2. Dispositif oscillateur selon la revendication 1, **caractérisé en ce que** ledit résonateur comporte en outre un autre mode de vibration en flexion, dit premier overtone de flexion, à une troisième fréquence supérieure à la fréquence dudit mode fondamental de vibration en torsion.

3. Dispositif oscillateur selon la revendication 1 ou 2, **caractérisé en ce que** ledit circuit électronique d'entretien comprend un amplificateur inverseur (2) comprenant une entrée (A) sur laquelle est connectée une première capacité de charge ($C_1$) et une sortie (B) sur laquelle est connectée une seconde capacité de charge ($C_2$), ledit résonateur à quartz (1) étant connecté dans le chemin de contre-réaction dudit amplificateur inverseur (2), ce circuit électronique d'entretien comprenant en outre une résistance de contre-réaction ($R_F$) connectée entre l'entrée (A) et la sortie (B) dudit amplificateur inverseur (2).

4. Dispositif oscillateur selon la revendication 3, **caractérisé en ce que** ledit amplificateur inverseur (2) est un inverseur CMOS comportant, connectés en série entre un potentiel d'alimentation ($V_{DD}$) et un potentiel de masse ($V_{SS}$), un premier transistor (4a) de type p et un deuxième transistor (4b) de type n dont les drains sont connectés en commun et forment la sortie (B) de l'inverseur, et dont les grilles sont connectées en commun et forment l'entrée (A) de l'inverseur.

5. Dispositif oscillateur selon la revendication 3 ou 4, **caractérisé en ce que** la valeur de ladite résistance de contre-réaction ($R_F$) est déterminée de manière à réduire sensiblement la transconductance maximale ($g_{m,max}$) relative au mode fondamental de vibration en flexion du résonateur.

6. Dispositif oscillateur selon l'une quelconque des revendications précédentes, **caractérisé en ce que** ledit résonateur se présente sous la forme d'un diapason et est agencé de sorte que la fréquence dudit mode fondamental de vibration en torsion est sensiblement égale à un multiple de 32,768 kHz.

7. Dispositif oscillateur selon la revendication 6, **caractérisé en ce qu'**il comporte en outre un circuit diviseur connecté sur la sortie du circuit électronique d'entretien et permettant de dériver un signal d'oscillation à une fréquence de 32,768 kHz.

8. Dispositif oscillateur selon la revendication 6 ou 7, **caractérisé en ce que** la fréquence dudit mode fondamental de vibration en torsion est sensiblement égale à 393,216 kMz.

9. Dispositif oscillateur selon la revendication 7, **caractérisé en ce que** la fréquence dudit mode fondamental de vibration en torsion est sensiblement égale à 393,216 kHz et **en ce que** ledit circuit diviseur et un circuit diviseur par douze.

10. Dispositif oscillateur selon l'une quelconque des revendications précédentes **caractérisé en ce que** ledit résonateur et ledit circuit électronique d'entretien sont disposés dans un même boîtier.

**Claims**

1. Low frequency oscillator device including a quartz resonator and an electronic maintenance circuit for maintaining the vibrations of said quartz resonator, **characterised in that**:

- said quartz resonator has a single cutting angle defined by a rotation at a determined angle ($\theta$) about the crystallographic axis X of said quartz, so that said resonator includes at least one fundamental flexural vibrating mode at a first frequency and a fundamental torsional vibrating mode at a second frequency higher than said first frequency; and

- said electronic maintenance circuit for maintaining the vibrations of the resonator is an inverting amplifier circuit (2) whose transconductance value ($g_m$) is determined such that said device cannot oscillate according to said fundamental flexural vibrating mode but according to said fundamental torsional vibrating mode of said resonator.

2. Oscillator device according to claim 1, **characterised in that** said resonator also includes another flexural vibrating mode, called the first flexural overtone mode, at a third frequency higher than the frequency of said fundamental torsional vibrating mode.

3. Oscillator device according to claim 1 or 2, **characterised in that** said electronic maintenance circuit includes an inverting amplifier (2) including an input (A) at which is connected a first load capacitor ($C_1$) and an output (B) at which is connected a second load capacitor ($C_2$), said quartz resonator (1) being connected in the feedback path of said inverting amplifier (2), this electronic maintenance circuit also including a feedback resistor ($R_F$) connected across the input (A) and the output (B) of said inverting amplifier (2).

4. Oscillator device according to claim 3, **characterised in that** said inverting amplifier (2) is a CMOS inverter including, connected in series between a power supply potential ($V_{DD}$) and an earth potential ($V_{SS}$), a first p type transistor (4a) and a second n type transistor (4b) whose drains are connected to each other and form the output (B) of the inverter, and whose gates are connected to each other and form the input (A) of the inverter.

5. Device according to claim 3 or 4, **characterised in that** the value of said feedback resistor ($R_F$) is determined so as to substantially reduce the maximum transconductance ($g_{m,max}$) relative to the fundamental flexural vibrating mode of the resonator.

6. Oscillator device according to any one of the preceding claims, **characterised in that** said resonator has the shape of a tuning fork and is arranged so that the frequency of said fundamental torsional vibrating mode is substantially equal to a multiple of 32,768 kHz.

7. Oscillator device according to claim 6, **characterised in that** it further includes a divider circuit which is connected at the output of the electronic maintenance circuit and which allows an oscillation signal to be derived at a frequency of 32,768 kHz.

8. Oscillator device according to claim 6 or 7, **characterised in that** the frequency of said fundamental torsional vibrating mode is substantially equal to 393,216 kHz.

9. Oscillator device according to claim 7, **characterised in that** the frequency of said fundamental torsional vibrating mode is substantially equal to 393,216 kHz and **in that** said divider circuit is a divider-by-twelve circuit.

10. Oscillator device according to any one of the preceding claims, **characterised in that** said resonator and said electronic maintenance circuit are arranged in a same case.

**Patentansprüche**

1. Niederfrequenz-Oszillatorvorrichtung, die einen Quarzresonator und eine elektronische Schaltung für die Aufrechterhaltung der Oszillationen des Quarzresonators umfaßt, **dadurch gekennzeichnet, daß**:

- der Quarzresonator einen einzigen Schnittwinkel aufweist, der durch eine Drehung um einen bestimmten Winkel ($\theta$) um die kristallographische Achse X des Quarzes definiert ist, derart, daß der Resonator wenigstens eine Biegungsgrundschwingungsart mit einer ersten Frequenz und eine Torsionsgrundschwingungsart mit einer zweiten Frequenz, die höher als die erste Frequenz ist, aufweist; und

- die elektronische Schaltung für die Aufrechterhaltung der Oszillationen des Resonators eine Schaltung (2) mit einem invertierenden Verstärker ist, deren Transkonduktanzwert ($g_m$) in der Weise bestimmt ist, daß die Vorrichtung nicht in der Biegungsgrundschwingungsart, sondern in der Torsionsgrundschwingungsart des Resonators oszillieren kann.

2. Oszillatorvorrichtung nach Anspruch 1, **dadurch gekennzeichnet, daß** der Resonator außerdem eine weitere Biegungsschwingungsart, die erster Biegungsoberton genannt wird und eine dritte Frequenz besitzt, die höher als die Frequenz der Torsionsgrundschwingungsart ist, besitzt.

3. Oszillatorvorrichtung nach Anspruch 1 oder 2, **dadurch gekennzeichnet, daß** die elektronische Aufrechterhaltungsschaltung einen invertierenden Verstärker (2) umfaßt, der einen Eingang (A), an den eine erste Lastkapazität ($C_1$) angeschlossen ist, sowie einen Ausgang (B), an den eine zweite Lastkapazität ($C_2$) angeschlossen ist, umfaßt, wobei der Quarzresonator (1) in den Rückkopplungspfad des invertierenden Verstärkers (2) geschaltet ist, wobei diese elektronische Aufrechterhaltungsschaltung außerdem einen Rückkopplungswiderstand ($R_F$) umfaßt, der zwischen den Eingang (A) und den Ausgang (B) des invertierenden Verstärkers (2) geschaltet ist.

4. Oszillatorvorrichtung nach Anspruch 3, **dadurch gekennzeichnet, daß** der invertierende Verstärker (2) ein CMOS-Inverter ist, der zwischen einem Versorgungspotential ($V_{DD}$) und einem Massepotential ($V_{SS}$) in einer Reihenschaltung einen ersten p-Transistor (4a) und einen zweiten n-Transistor (4b) umfaßt, deren Drains miteinander verbunden sind und den Ausgang (B) des Inverters bilden und deren Gates miteinander verbunden sind und den Eingang (A) des Inverters bilden.

5. Oszillatorvorrichtung nach Anspruch 3 oder 4, **dadurch gekennzeichnet, daß** der Wert des Rückkopplungswiderstandes ($R_F$) in der Weise bestimmt ist, daß die maximale Transkonduktanz ($g_{m,max}$) relativ zur Biegungsgrundschwingungsart des Resonators wesentlich reduziert ist.

6. Oszillatorvorrichtung nach einem der vorhergehenden Ansprüche, **dadurch gekennzeichnet, daß** der Resonator die Form einer Stimmgabel hat und so beschaffen ist, daß die Frequenz der Torsionsgrundschwingungsart im wesentlichen gleich einem Vielfachen von 32,768 kHz ist.

7. Oszillatorvorrichtung nach Anspruch 6, **dadurch gekennzeichnet, daß** sie außerdem eine Teilerschaltung umfaßt, die an den Ausgang der elektronischen Aufrechterhaltungsschaltung angeschlossen ist und ermöglicht, ein Oszillationssignal mit einer Frequenz von 32,768 kHz abzuzweigen.

8. Oszillatorvorrichtung nach Anspruch 6 oder 7, **dadurch gekennzeichnet, daß** die Frequenz der Torsionsgrundschwingungsart im wesentlichen gleich 393,216 kHz ist.

9. Oszillatorvorrichtung nach Anspruch 7, **dadurch gekennzeichnet, daß** die Frequenz der Torsionsgrundschwingungsart im wesentlichen gleich 393,216 kHz ist und daß die Teilerschaltung eine Teilerschaltung durch zwölf ist.

10. Oszillatorvorrichtung nach einem der vorhergehenden Ansprüche, **dadurch gekennzeichnet, daß** der Resonator und die elektronische Aufrechterhaltungsschaltung im selben Gehäuse angeordnet sind.

Fig. 1

Fig. 2

**Fig. 3a**

**Fig. 3b**

Fig. 4

## Fig. 5

EP 1 111 770 B1